# FASCICULE DE BREVET EUROPEEN

(11) **EP 0 674 265 B1**
(45) Date de publication et mention de la délivrance du brevet: **03.02.1999**
(21) Numéro de dépôt: 95400510.4
(22) Date de dépôt: 10.03.1995
(51) Int. Cl.: G06F 11/26, G06F 17/50

(54) **Procédé et dispositif d'élaboration de tests de cartes électroniques**
Verfahren und Vorrichtung zur Erzeugung von Tests für elektronische Karten
Method and apparatus to generate tests for electronic boards

(30) Priorité: 25.03.1994 FR 9403940
(43) Date de publication de la demande: 27.09.1995
(73) Titulaire: AEROSPATIALE, Société Nationale Industrielle, 75781 Paris (FR)
(72) Inventeur: Bougourd, Denis, F-78180 Montigny le Bretonneux (FR); Hourdin, Etienne, F-78220 Viroflay (FR)
(74) Mandataire: de Saint-Palais, Arnaud Marie

(56) Documents cités:
- EP-A- 0 508 619
- DE-A- 3 942 082
- US-A- 5 282 146
- RAUCH-HINDIN, WENDY B. 'Artificial Intelligence in Business, Science and Industry, Vol.II, Applications, Chapitre 10', pp.180-206., PRENTICE HALL, ENGLEWOOD CLIFFS, US,1985

## Description

La présente invention concerne un procédé et un dispositif pour élaborer des séquences de test automatique de cartes électroniques.

Elle s'applique notamment, mais non exclusivement, aux systèmes de test automatique. Ces systèmes ont pour but de recréer l'environnement réel de la carte électronique à tester et de mesurer ses réactions de manière à détecter ses défauts éventuels. Afin de pouvoir s'adapter à la très grande variété de cartes électroniques et d'être le plus polyvalents possible, ces systèmes possèdent un grand nombre de ressources de génération de signaux et de mesure. Par ailleurs, pour pouvoir réaliser automatiquement le test d'une carte électronique, ils sont programmables.

On distingue plusieurs techniques de test de cartes électroniques.
La technique MDA d'analyse de défauts de fabrication se situe au niveau physique le plus bas. Elle consiste à détecter les courts-circuits, les discontinuités au niveau des équipotentielles, et les composants manquants.

La technique in-situ de niveau électrique consiste à vérifier que chaque composant actif et passif fonctionne correctement et indépendamment de son environnement.

Le test fonctionnel consiste à vérifier que les fonctions ont été correctement réalisées en déterminant leur tables de vérité ou leur fonctions de transfert.

Les deux premières techniques, MDA et in-situ impliquent que les différentes équipotentielles de la carte sont directement accessibles à l'aide d'une interface mécanique telle qu'une planche à clous comprenant une multiplicité de clous destinés à venir en contact électrique avec les équipotentielles, tandis que la troisième fonctionnelle n'accède qu'aux connecteurs de la carte.

L'élaboration de la procédure de test automatique d'une carte électronique nécessite tout d'abord des connaissances de base en électronique et la connaissance des méthodes de test. Il est également nécessaire de connaître les spécificités du système de test automatique et notamment son langage de commande.
Le raisonnement d'élaboration d'un tel test ne peut donc se limiter au seul schéma électronique de la carte à tester.
En effet, la démarche généralement suivie pour élaborer un test consiste tout d'abord à décrire dans un langage spécifique au système de test, l'architecture de la carte, composant par composant et équipotentielle par équipotentielle, en partant des connecteurs. Ensuite, en fonction de la technique de test employée, il s'agit de définir les stimuli à appliquer aux différents points de la carte, et les points de mesure en association avec le type de mesure à effectuer, ainsi que les valeurs attendues à chaque point de mesure en fonction du stimuli appliqué.

Ces étapes entièrement manuelles sont bien entendues suivies par une étape de mise au point en vue d'obtenir une séquence de test opérationnelle.

Il apparaît que cette démarche est longue et fastidieuse, et donc très coûteuse, et ce d'autant plus que la carte à tester est complexe.

On a donc cherché à simplifier la réalisation de tels tests, et un premier pas a été franchi en utilisant les données issues des outils de conception assistée par ordinateur pour automatiser l'étape de description de la carte.

Les étapes suivantes restent purement manuelles et requièrent des compétences à la fois en électronique, en test, et en programmation. Cela implique que l'ingénieur de test n'est pas uniquement concentré sur son activité de test, son attention étant dispersée entre des problèmes de test de cartes électroniques et des problèmes de langage de commande et de programmation. En outre, il doit avoir en permanence à côté de lui, le schéma électronique et le schéma d'implantation des composants de la carte qui se présentent généralement sous la forme de plans sur support papier de grand format difficiles à manipuler.

Ainsi, le dispositif décrit dans le document "Artificial Intelligence in Business, Science and Industry, Vol. II: Applications, Wendy B Rauch-Hindin, US Englewood Cliffs, Prentice Hall, 1985, Chapitre 10, pages 180-206" requiert la connaissance d'un langage de programmation et de sa syntaxe pour définir un ensemble de règles auxquelles doit satisfaire la carte à tester pour être considérée en bon fonctionnement.

La présente invention a pour but de supprimer ces inconvénients. Elle propose à cet effet un procédé pour le test d'une carte électronique à l'aide d'un système de test automatique comprenant un processeur apte à exécuter une séquence de test, et des moyens de génération et de mesure de signaux électriques, ledit système étant connecté à la carte au moyen d'un circuit d'interface permettant d'appliquer à la carte des stimuli délivrés par lesdits moyens de génération et d'en mesurer les effets à l'aide desdits moyens de mesure.
Ce procédé est caractérisé en ce qu'il met en oeuvre un calculateur connecté au système de test et comprend les phases suivantes :
- l'introduction dans le calculateur et la mise en forme des informations décrivant l'architecture de la carte électronique, et servant à la fabrication automatisée de ladite carte,
- l'affichage par le calculateur du schéma électronique de la carte sur un écran de visualisation, à partir desdites informations,
- le dialogue entre le calculateur et l'opérateur à l'aide du schéma affiché à l'écran et de moyens de désignation et de commande, au cours duquel l'opérateur définit une séquence de test, ce dialogue comprenant la désignation successive par l'opérateur d'équipotentielles de la carte à tester, chacune de ces désignations entraînant l'affichage par le calculateur d'un menu de sélection de moyens de génération et de mesure, la sélection par l'opérateur d'un de ces moyens de génération et de mesure provoquant l'affichage par le calculateur d'une image représentant un panneau de commande du moyen de génération ou de mesure sélectionné, sur lequel l'opérateur peut agir pour introduire le mode de fonctionnement souhaité du moyen de génération ou de mesure sélectionné,
- un premier déroulement automatique de la séquence de test sur ledit système de test ou sur un simulateur, au cours duquel sont mémorisés les signaux électriques mesurés par lesdits moyens de mesure, et
- un second déroulement automatique de la séquence de test sur ledit système de test, au cours duquel les signaux mesurés sont comparés avec ceux qui ont été mémorisés lors dudit premier déroulement, la carte ainsi testée étant déclarée en bon fonctionnement si aucune différence n'a été détectée lors de ces comparaisons.

De cette manière, l'ingénieur de test n'a plus à connaître le langage de commande et de programmation du système de test, le calculateur mettant à sa disposition, par l'intermédiaire de l'écran et des moyens de désignation et de commande, les schémas électroniques et physiques de la carte, ainsi que les appareils de génération de signaux et de mesure.

Selon une particularité de l'invention, il comprend une étape de modification et d'adaptation du schéma électronique de la carte, affiché à l'écran, en fonction du système de test et du type de test à réaliser, par action directe de l'opérateur sur le schéma affiché à l'aide des moyens de désignation et de commande.

De cette manière, l'opérateur a la possibilité de modifier les schémas issus de l'étape de conception de la carte qui, bien souvent ne sont pas adaptés au test, et ne prévoient pas l'accessibilité de certaines équipotentielles, nécessaire au test de certaines fonctions de la carte.

Avantageusement, à l'issue de la réalisation de la séquence de test automatique, le procédé selon l'invention comprend, à partir desdites informations complétées et adaptées, la production d'informations permettant la fabrication automatisée de la carte électronique au format des données produites par un outil de conception assistée par ordinateur.

Cette disposition permet de corriger les défauts de conception constatés lors de l'élaboration de la séquence de test, et notamment, de rendre accessibles les équipotentielles qui ne l'étaient pas, en vue de permettre la réalisation d'un test le plus exhaustif possible.
La revendication indépendante 14 concerne le dispositif pour la mise en oeuvre du procédé selon l'invention.
Un mode de réalisation du procédé selon l'invention sera décrit ci-après, à titre d'exemple non limitatif, avec référence aux dessins annexés dans lesquels :
La figure 1 représente schématiquement un dispositif permettant la mise en oeuvre du procédé selon l'invention ;
la figure 2 montre l'enchaînement des principales phases du procédé ;
les figures 3 à 7 montrent le schéma de portions de circuit électronique et les différentes opérations susceptibles d'être effectuées sur ce schéma.

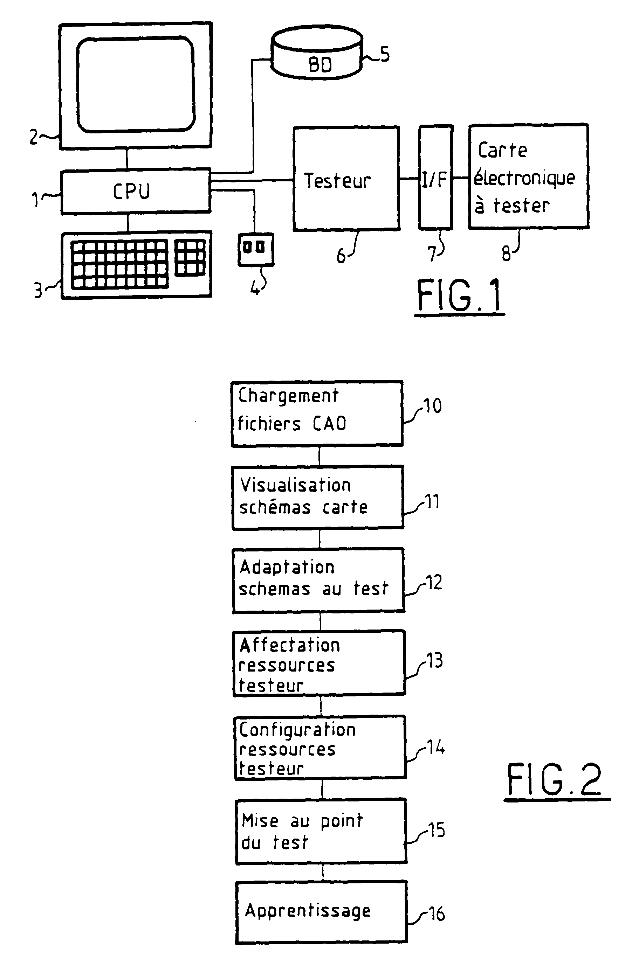

Le dispositif de la figure 1 comprend une unité centrale 1 connectée à un écran de visualisation 2 et à au moins un organe de commande tel qu'un clavier 3 ou une souris 4. Cette unité centrale 1 est également raccordée à une unité de mémoire de masse 5 et un système de test de cartes électroniques, auquel vient se connecter la carte à tester 8 par l'intermédiaire d'une interface 7.

Un tel système de test 6 comprend généralement un processeur apte à commander d'une part un ensemble d'appareils de mesure et de génération de signaux électriques, et d'autre part, l'interface 7 pour connecter sur commande ces appareils aux différentes équipotentielles de la carte.

Au cours d'une première phase 10 du procédé selon l'invention (figure 2), les fichiers de données produits par l'outil de conception assistée par ordinateur en vue d'une fabrication automatisée de la carte électronique à tester 8 sont introduits dans l'unité centrale 1. Ces fichiers contiennent toutes les informations nécessaires à la description physique et logique de la carte 8.
Ces informations sont traitées par l'unité centrale 1 pour être normalisées et réorganisées en une base de données stockée dans la mémoire de masse 5. Elles permettent notamment de reconstituer le schéma électronique des circuits de la carte et le schéma d'implantation des composants électroniques et des équipotentielles de la carte 8.
Ces deux schémas peuvent sur commande de l'ingénieur de test, apparaître à l'écran de visualisation 2 (phase 2), soit l'un après l'autre en plein écran, soit simultanément dans deux fenêtres distinctes dans lesquelles on peut déplacer le schéma afin de visualiser les parties non affichées. Il est également possible d'agrandir une portion de schéma afin de pouvoir en visualiser les détails.

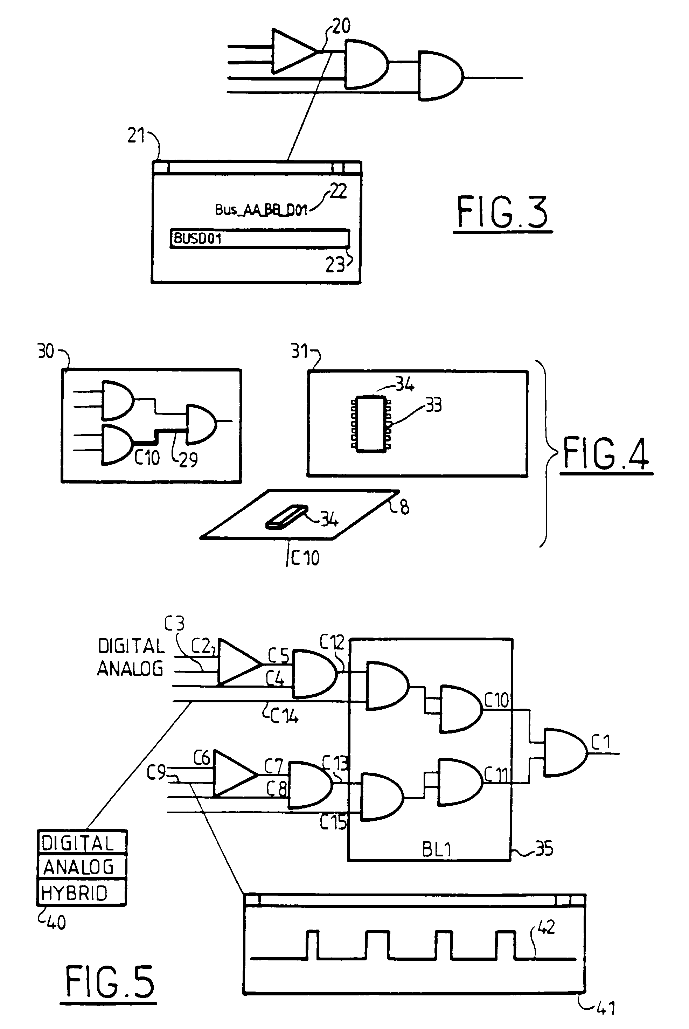

La phase suivante 12 consiste à adapter ces deux schémas au test. En effet, il est fréquent que les noms des différents éléments donnés par l'outil de conception assistée par ordinateur soient incompatibles avec les règles de commande du système de test. Il faut donc les modifier. Pour cela l'ingénieur de test procède de la façon suivante, comme illustré à la figure 3. Il déclenche la commande "changer le nom" accessible par exemple par un menu général, puis il désigne à l'aide de la souris l'élément dont il souhaite modifier le nom.

Sur la figure 3, une fenêtre 21 est apparue à l'écran 2 à la suite de la désignation d'une équipotentielle 20 par l'ingénieur de test. Dans cette fenêtre 21, est affiché le nom 22 de l'équipotentielle désignée et un champ de saisie 23 est activé de manière à permettre à l'ingénieur de test d'introduire un nouveau nom à l'aide du clavier 3. L'unité centrale 1 accède alors à la base de données pour y ajouter ce nouveau nom en association avec l'équipotentielle désignée.

En outre, les données issues de la conception ne contiennent pas toutes les données nécessaires au test, comme par exemple, la position des clous de test par rapport aux équipotentielles, dans le cas d'un test de niveau physique ou électrique. Pour cela, l'ingénieur de test commande l'affichage simultané du schéma électronique 30 et du schéma d'implantation physique des composants 31 de la carte (figure 4), et désigne successivement sur le schéma d'implantation des composants, toutes les pattes de connexion de composants sur lesquelles ont été prévus des clous, tel que C10, au niveau de l'interface 7. La désignation d'une patte de connexion 33 à l'aide de la souris provoque la signalisation de la patte désignée et de l'équipotentielle 29 correspondante sur le schéma électronique 30, ainsi que l'affichage d'une fenêtre destinée à la saisie du numéro du clou correspondant.

Dans le cas, d'un test fonctionnel, cette étape comprend également le découpage graphique de la carte 8 en blocs logiques. Cette opération peut être effectuée à l'aide de la souris 4 en désignant successivement sur le schéma électronique, soit un ensemble de zones rectangulaires 35 (figure 5), soit les composants électroniques du bloc logique. A la suite de ces désignations, une fenêtre de saisie apparaît à l'écran pour permettre à l'ingénieur de test d'affecter un nom, par exemple BL1, à ce bloc logique 35.

La phase suivante 13 consiste à affecter les ressources du système de test aux différentes équipotentielles. En test physique ou électrique, ces équipotentielles sont accessibles par les clous, tandis qu'en test fonctionnel, seules les entrées et sorties de la carte sont accessibles par l'interface de test 7. Les ressources du système de test 6 comprennent des générateurs de signaux et des appareils de mesure.

Pour réaliser cette affectation, il suffit de désigner un à un les points de mesure ou de génération à l'aide de la souris et de préciser la ressource du système de test que l'on désire lui affecter.
Au cours de cette phase, la désignation d'une équipotentielle provoque l'affichage d'une fenêtre 40 permettant de préciser le type de signal transitant par cette équipotentielle, à savoir, numérique, analogique ou hybride, c'est-à-dire, numérique et analogique. Une fois que le type de signal à été choisi, le libellé du type de signal apparaît à proximité de l'équipotentielle correspondante.
Le choix du type de signal pour chaque équipotentielle permet de créer le plan de câblage de l'interface de test, et, une fois ce câblage réalisé pour chaque équipotentielle, de pouvoir appliquer l'une des ressources compatibles avec le type de signal sélectionné.

La phase suivante 14 consiste à déterminer le séquencement du test en programmant les ressources du système de test à appliquer successivement à chaque équipotentielle précédemment identifiée. Ainsi, les commandes à appliquer successivement aux différentes ressources du système de test sont mémorisées dans l'ordre selon lequel elles sont introduites par l'ingénieur de test en une séquence de test qui pourra être déroulée pour procéder au test automatique de la carte.

Pour établir cette séquence de test, l'ingénieur de test désigne successivement à l'aide de la souris chaque équipotentielle à laquelle il souhaite affecter une ressource du système de test selon un ordre déterminé. Ainsi, par exemple, pour tester une fonction, l'ingénieur de test commence par désigner successivement l'ensemble des points de génération, c'est-à-dire, les points auxquels il désire appliquer un signal, et donne la forme des signaux à appliquer respectivement à ces points de génération. Puis il désigne les points de mesure et introduit la forme des signaux attendus en fonction des signaux d'entrée.

Chaque désignation d'équipotentielle provoque l'affichage d'une fenêtre donnant la liste des générateurs ou appareils de mesure mis à disposition par le système de test, en fonction du type de signal affecté à l'équipotentielle lors de la phase précédente.

La sélection d'un appareil entraîne l'affichage d'une nouvelle fenêtre permettant de définir les paramètres de fonctionnement de celui-ci.
Ainsi, par exemple, la désignation par l'ingénieur de test d'un générateur ou d'un appareil de visualisation de signaux numériques provoque l'affichage d'une fenêtre 41 dans laquelle l'ingénieur de test peut définir la forme du signal 42 à appliquer ou à détecter sur l'équipotentielle précédemment désignée.

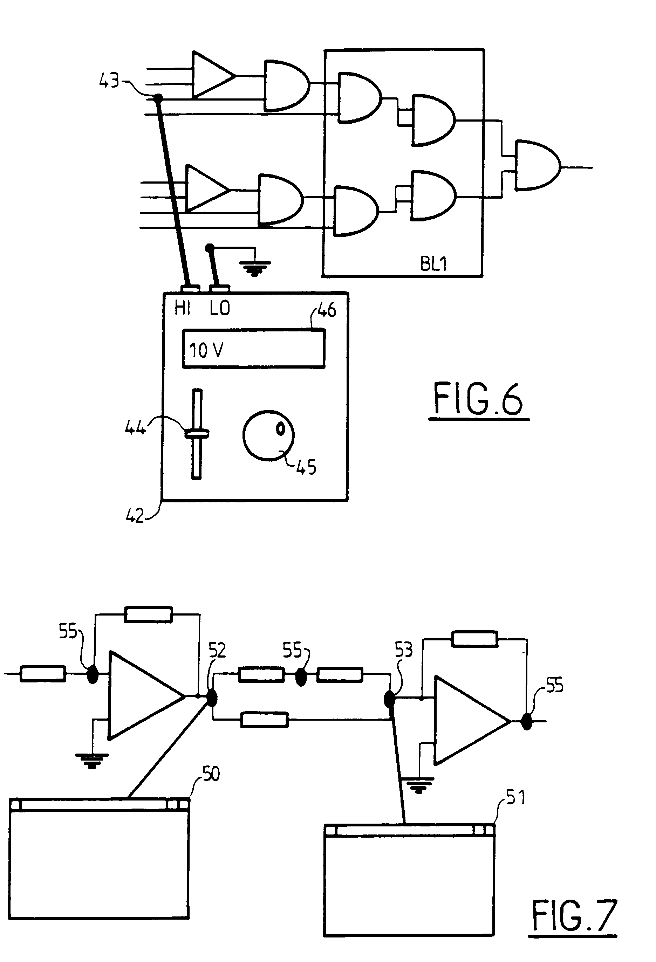

Dans les autres cas, la sélection d'un appareil de génération de signaux ou de mesure provoque l'affichage d'une représentation 42 du panneau de commande de l'appareil sélectionné (sur la figure 6, un générateur de tension) connecté à l'équipotentielle considérée 43. Les boutons de commande 44,45 de l'appareil ainsi représenté peuvent être actionnés par l'ingénieur de test à l'aide de la souris, ce qui entraîne la mise à jour des afficheurs 46 de l'appareil.
Il convient de noter que chaque étape de test peut être exécutée individuellement. On peut donc, avec un nombre réduit de manipulations sur les schémas affichés à l'écran de visualisation 2, affecter des ressources du système de test 6 aux équipotentielles de la carte 8, et visualiser les réactions de la carte grâce aux résultats fournis par les instruments de mesure.

Une fois que le séquencement du test est défini et que les ressources du système de test sont programmées pour chaque étape du test, il s'agit, au cours de la phase 15 de mettre au point le test en activant son exécution pas à pas sur le système de test ou sur un simulateur. Cette phase de mise au point permet, lors de chaque étape de la séquence de test, de visualiser dans des fenêtres respectives 50,51, les paramètres de génération et les résultats des mesures en liaison avec les points de génération 52 et les points de mesure 53. Ces fenêtres 50,51 permettent également à l'ingénieur de test d'ajuster en interactif les paramètres de génération et de mesure.

En test in-situ, cette phase permet à l'ingénieur de test de positionner des points de garde 55 de manière à pouvoir effectuer des mesures sur une partie du circuit tout en s'affranchissant des effets du reste du circuit.

La phase 16 consiste à dérouler complètement la séquence de test une fois mise au point dans le but de la valider, et en même temps, de réaliser l'apprentissage de la carte. Cet apprentissage consiste à mémoriser dans la base de données tous les signaux mesurés en vue de pouvoir les comparer avec les signaux mesurés lors d'exécutions ultérieures de la séquence de test, et ainsi, de pouvoir déclarer bonne ou mauvaise une carte ainsi testée. Cette phase peut être réalisée aussi bien à l'aide du système de test 6 que d'un simulateur capable de simuler le fonctionnement de la carte à tester.

Cette phase d'apprentissage est particulièrement utile lorsque l'ingénieur de test n'est pas capable d'indiquer la forme des signaux attendus. Il en est ainsi, dans le cas d'étapes de test consistant à lire le contenu de mémoires pré-programmées. Lors du déroulement de la séquence de test, le système de test 6 enregistre le contenu de la mémoire lue et le restitue au calculateur 1 qui le mémorise au niveau de la base de données.

Cette phase permet également de procéder à la détection de panne en mode interactif avec le système de test en vue de localiser une panne sur une carte. A cet effet, le schéma d'implantation est affiché à l'écran, et l'ingénieur de test peut y visualiser les points indiqués par le système de test sur lesquels il doit positionner une sonde. Lors de cette phase, le système de test 6 fournit à l'unité centrale 1 les informations suivantes :
- le nom de l'équipotentielle,
- le type et le numéro du composant,
- le numéro de patte de connexion du composant correspondant à l'équipotentielle, et
- le résultat du test.

Il convient de noter que toutes les informations de test introduites au cours des différentes phases d'élaboration de la séquence de test sont mémorisées et rangées au fur et à mesure dans la base de données. En fin d'élaboration de cette séquence, la base de données est vérifiée et réorganisée en vue de pouvoir exécuter celle-ci de manière efficace.

Le procédé selon l'invention comprend une phase supplémentaire au cours de laquelle sont élaborés de nouveaux fichiers au format compatible avec les fichiers issus de l'outil de conception assistée par ordinateur. Ces fichiers permettent de fabriquer de nouvelles cartes corrigées sur le plan de la conception pour être facilement testées et dépannées.

## Revendications

1. Procédé pour le test d'une carte électronique à l'aide d'un système de test automatique (6) comprenant un processeur apte à exécuter une séquence de test, et des moyens de génération et de mesure de signaux électriques, ledit système étant connecté à la carte (8) au moyen d'un circuit d'interface (7) permettant d'appliquer à la carte des stimuli délivrés par lesdits moyens de génération et d'en mesurer les effets à l'aide desdits moyens de mesure, caractérisé en ce qu'il met en oeuvre un calculateur (1) connecté au système de test (6) et comprend les phases suivantes :
- l'introduction (10) dans le calculateur (1) et la mise en forme d'informations décrivant l'architecture de la carte électronique (8), et servant à la fabrication automatisée de ladite carte,
- l'affichage (11) par le calculateur (1) du schéma électronique de la carte sur un écran de visualisation (2), à partir desdites informations,
- le dialogue (12,13,14) entre le calculateur (1) et l'opérateur à l'aide du schéma affiché à l'écran (2) et de moyens (3,4) de désignation et de commande, au cours duquel l'opérateur définit une séquence de test, ce dialogue comprenant la désignation successive par l'opérateur d'équipotentielles de la carte à tester, chacune de ces désignations entraînant l'affichage par le calculateur d'un menu de sélection de moyens de génération et de mesure, la sélection par l'opérateur d'un de ces moyens de génération et de mesure provoquant l'affichage par le calculateur d'une image représentant un panneau de commande du moyen de génération ou de mesure sélectionné, sur lequel l'opérateur peut agir pour introduire le mode de fonctionnement souhaité du moyen de génération ou de mesure sélectionné,
- un premier déroulement automatique (16) de la séquence de test sur ledit système de test (6) ou sur un simulateur, au cours duquel sont mémorisés les signaux électriques mesurés par lesdits moyens de mesure, et
- un second déroulement automatique de la séquence de test sur ledit système de test (6) au cours duquel les signaux mesurés sont comparés avec ceux qui ont été mémorisés lors dudit premier déroulement (16), la carte (8) ainsi testée étant déclarée en bon fonctionnement si aucune différence n'a été détectée lors de ces comparaisons.

2. Procédé selon la revendication 1,
caractérisé en ce que durant la phase de dialogue entre le calculateur (1) et l'opérateur, il comprend une étape de modification et d'adaptation du schéma électronique de la carte, affiché à l'écran (2), en fonction du système de test (6) et du type de test à réaliser, par action directe de l'opérateur sur le schéma affiché à l'aide des moyens de désignation et de commande.

3. Procédé selon la revendication 2,
caractérisé en ce qu'il comprend, à l'issue dudit premier déroulement (16), la mise des informations utilisées par la séquence de test, sous une forme compatible avec l'outil de conception assistée par ordinateur.

4. Procédé selon la revendication 1 ou 2,
caractérisé en ce que lesdites informations servant à la fabrication automatisée de ladite carte (8) sont délivrées par un outil de conception assistée par ordinateur.

5. Procédé selon l'une des revendications précédentes,
caractérisé en ce qu'il comprend l'affichage (11) à l'écran de visualisation (2) du schéma électronique (30) et du schéma d'implantation (31) des composants électroniques (34) et des équipotentielles de la carte (8).

6. Procédé selon l'une des revendications précédentes,
caractérisé en ce qu'il comprend la désignation successive sur ledit schéma affiché à l'écran, à l'aide d'un moyen de désignation (4), des équipotentielles de la carte à tester et l'affectation de ces dernières à des clous de test (Ci).

7. Procédé selon l'une des revendications précédentes,
caractérisé en ce qu'il comprend la désignation successive (13) sur ledit schéma affiché à l'écran, à l'aide d'un moyen de désignation (4), des équipotentielles de la carte et la sélection du type de signal, numérique ou analogique, transitant dans ces dernières.

8. Procédé selon la revendication 6,
caractérisé en ce qu'il comprend l'élaboration automatique du plan de câblage de l'interface de connexion (7) entre le système de test et la carte à tester, à l'issue de la sélection du type de signal transitant dans chaque équipotentielle.

9. Procédé selon l'une revendications 5 à 7,
caractérisé en ce que l'ordre suivant lequel sont désignées les équipotentielles et sont définis lesdits signaux détermine l'ordre de séquencement du test.

10. Procédé selon l'une des revendications précédentes,
caractérisé en ce qu'il comprend l'exécution pas à pas (15) de ladite séquence de test, l'affichage sur l'écran (2) et l'ajustement à chaque pas par l'opérateur, des paramètres définissant la forme des signaux à appliquer (50) et à détecter (51) aux différentes équipotentielles (52,53) de la carte (8).

11. Procédé selon l'une des revendications précédentes,
caractérisé en ce que toutes les informations utilisées pour le test sont stockées et organisées sous la forme d'une base de données (5).

12. Procédé selon l'une des revendications précédentes,
caractérisé en ce qu'il comprend un mode de détection de panne en interactif au cours duquel les points (33) indiqués par le système de test (6), sur lesquels l'opérateur doit placer une sonde, sont signalés sur le schéma d'implantation (31) des composants de la carte (8) sur l'écran de visualisation (2).

13. Procédé selon l'une des revendications précédentes,
caractérisé en ce qu'il comprend un mode de détection de panne en interactif au cours duquel les équipotentielles (29) indiquées par le système de test (6), sur lesquelles l'opérateur doit placer une sonde, sont signalées sur le schéma électronique (30) de la carte (8) affiché sur l'écran de visualisation (2).

14. Dispositif pour la mise en oeuvre du procédé selon l'une des revendications précédentes,
caractérisé en ce qu'il comprend une unité centrale (1) connectée à :
- un système de test automatique (6) de cartes électroniques, du type comprenant un processeur apte à commander un ensemble d'appareils de génération de signaux et de mesure, ledit système étant raccordé à la carte électronique (8) à tester par l'intermédiaire d'une interface (7).
- au moins un organe de commande tel qu'un clavier (3) et une souris (4),
- un écran de visualisation (2) sur lequel est affiché le schéma électronique de la carte électronique (8),
l'unité centrale (1) permettant à un opérateur, en interactif à partir dudit schéma, de connecter lesdits appareils aux équipotentielles de la carte électronique, et de les commander pour appliquer à celles-ci des stimuli et en visualiser les effets sur l'écran de visualisation (2).

## Patentansprüche

1. Verfahren zum Testen einer elektronischen Karte mit Hilfe eines automatischen Testsystems (6), das einen Prozessor, der in der Lage ist, eine Testsequenz durchzuführen, und Mittel zur Erzeugung und Messung von elektrischen Signalen umfasst, wobei das System an die Karte (8) mittels einer Interface-Schaltung (7) angeschlossen ist, die es erlaubt, Stimuli, die von den Erzeugungsmitteln geliefert werden, an die Karte anzulegen und deren Auswirkungen mit Hilfe der Messmittel zu bestimmen, dadurch gekennzeichnet, dass es mit einem Rechner (1) arbeitet, der an das Testsystem (6) angeschlossen ist, und dass es die folgenden Phasen umfasst :
- die Eingabe (10) von Daten, welche die Architektur der elektronischen Karte (8) beschreiben und zur automatischen Fertigung der Karte dienen, in den Rechner (1) und deren Aufbereitung,
- die Anzeige (11) des Schaltplans der Karte auf einem Anzeigebildschirm (2) durch den Rechner, ausgehend von den Daten,
- den Dialog (12, 13, 14) zwischen dem Rechner (1) und der Bedienungsperson mit Hilfe des auf dem Bildschirm (2) angezeigten Plans und von Mitteln (3, 4) zur Kennzeichnung und zur Steuerung, in dessen Verlauf die Bedienungsperson eine Testsequenz festlegt, wobei dieser Dialog die aufeinanderfolgende Kenzeichnung von Äquipotentialflächen der zu testenden Karte durch die Bedienungsperson umfasst, wobei jede dieser Kennzeichnungen die Anzeige eines Menüs zur Auswahl von Erzeugungs- und Messmitteln durch den Rechner bewirkt und die Auswahl eines dieser Erzeugungs- und Messmttel durch die Bedienungsperson die Anzeige einer Grafik durch den Rechner hervorruft, die eine Schalttafel des ausgewählten Mittels zur Erzeugung oder zur Messung darstellt, welche die Bedienungsperson betätigen kann, um den gewünschten Betriebsmodus des ausgewählten Erzeugungs- oder Messmittels einzugeben,
- einen ersten automatischen Durchlauf (16) der Testsequenz auf dem Testsystem (6) oder auf einem Simulator, in dessen Verlauf die von den Messeinrichtungen gemessenen elektrischen Signale gespeichert werden, und
- einen zweiten automatischen Durchlauf der Testsequenz auf dem Testsystem (6), in dessen Verlauf die gemessenen Signale mit denen verglichen werden, die beim ersten Durchlauf (16) gespeichert wurden, wobei die so getestete Karte (8) für einwandfrei funktionsfähig befunden wird, wenn bei diesen Vergleichen kein Unterschied festgestellt wurde.

2. Verfahren nach Anspruch 1,
dadurch gekennzeichnet, dass es während der Dialogphase zwischen dem Rechner (1) und der Bedienungsperson einen Schritt zur Modifikation und zur Anpassung des auf dem Bildschirm (2) angezeigten Schaltplans der Karte in Abhängigkeit vom Testsystem (6) und von der Art des durchzuführenden Tests durch direkte Bearbeitung des angezeigten Plans mit Hilfe der Mittel zur Kennzeichnung und Steuerung durch die Bedienungsperson umfasst.

3. Verfahren nach Anspruch 2,
dadurch gekennzeichnet, dass es nach Beendigung des ersten Durchlaufs (16) die Aufbereitung der von der Testsequenz verwendeten Daten in einer zu dem CAD-Tool kompatiblen Form umfasst.

4. Verfahren nach Anspruch 1 oder 2,
dadurch gekennzeichnet, dass die Daten, die zur automatisierten Fertigung der Karte (8) dienen, von einem CAD-Tool geliefert werden.

5. Verfahren nach einem der vorhergehenden Ansprüche,
dadurch gekennzeichnet, dass es die Anzeige (11) des Schaltplans (30) und des Bauplans (31) der elektronischen Bauteile (34) sowie der Äquipotentialflächen der Karte (8) auf dem Anzeigebildschirm (2) umfasst.

6. Verfahren nach einem der vorhergehenden Ansprüche,
dadurch gekennzeichnet, dass es die aufeinanderfolgende Kennzeichnung der Äquipotentialflächen der zu testenden Karte auf dem am Bildschirm angezeigten Plan mit Hilfe eines Mittels zur Kennzeichnung (4) und deren Zuweisung zu Testnägeln (Ci) umfasst.

7. Verfahren nach einem der vorhergehenden Ansprüche,
dadurch gekennzeichnet, dass es die aufeinanderfolgende Kennzeichnung (13) der Äquipotentialflächen der zu testenden Karte auf dem am Bildschirm angezeigten Plan mit Hilfe eines Mittels zur Kennzeichnung (4) und die Auswahl des Signaltyps, d.h. digital oder analog, der diese durchläuft, umfasst.

8. Verfahren nach Anspruch 6,
dadurch gekennzeichnet, dass es die automatische Erstellung des Stromlaufplans der Anschluss-Schnittstelle (7) zwischen dem Testsystem und der zu testenden Karte nach Beendigung der Auswahl des durch jede Äquipotentialfläche hindurchgehenden Signaltyps umfasst.

9. Verfahren nach einem der Ansprüche 5 bis 7,
dadurch gekennzeichnet, dass die Reihenfolge, in der die Äquipotentialflächen gekennzeichnet werden und in der die Signale festgelegt werden, die Reihenfolge der Testsequenz bestimmt.

10. Verfahren nach einem der vorhergehenden Ansprüche,
dadurch gekennzeichnet, dass es die schrittweise Ausführung (15) der Testsequenz, die Anzeige auf dem Bildschirm (2) und bei jedem Schritt die Einstellung der Parameter, welche die Form der an die verschiedenen Äquipotentialflächen (52, 53) der Karte (8) anzulegenden (50) und zu detektierenden (51) Signale festlegen, durch die Bedienungsperson umfasst.

11. Verfahren nach einem der vorhergehenden Ansprüche,
dadurch gekennzeichnet, dass alle für den Test verwendeten Daten in Form einer Datenbank (5) gespeichert und organisiert sind.

12. Verfahren nach einem der vorhergehenden Ansprüche,
dadurch gekennzeichnet, dass es einen Modus zur interaktiven Erkennung von Störungen umfasst, bei dem die von dem Testsystem (6) angezeigten Punkte (33) auf welchen die Bedienungsperson eine Sonde plazieren muss, auf dem Bauplan (31) der Bauteile der Karte (8) auf dem Anzeigebildschirm (2) angezeigt werden.

13. Verfahren nach einem der vorhergehenden Ansprüche,
dadurch gekennzeichnet, dass es einen Modus zur interaktiven Erkennung von Störungen umfasst, bei dem die von dem Testsystem (6) angezeigten Äquipotentialflächen (29), auf welchen die Bedienungsperson eine Sonde plazieren muss, auf dem Schaltplan (30) der Karte (8), der auf dem Anzeigebildschirm (2) angezeigt wird, signaliert werden.

14. Vorrichtung zur Durchführung des Verfahrens nach einem der vorhergehenden Ansprüche,
dadurch gekennzeichnet, dass sie eine Zentraleinheit (1) umfasst, die angeschlossen ist an :
- ein System (6) zum automatischen Testen von elektronischen Karten des Typs, der einen Prozessor umfasst, welcher in der Lage ist, eine Gruppe von Geräten zur Signalerzeugung und zur Messung zu steuern, wobei das System über eine Schnittstelle (7) an die zu testende elektronische Karte (8) angeschlossen ist,
- wenigstens ein Steuergerät, wie eine Tastatur (3) und eine Maus (4), sowie
- einen Anzeigebildschirm (2), auf dem der Schaltplan der elektronischen Karte (8) angezeigt wird,
wobei die Zentraleinheit (1) einer Bedienungsperson erlaubt, die Geräte, ausgehend von dem Plan, interaktiv an die Äquipotentialflächen der elektronischen Karte anzuschliessen und sie so zu steuern, dass an diese Stimuli angelegt und deren Wirkungen auf dem Anzeigebildschirm (2) dargestellt werden.

## Claims

1. Method for testing an electronic board by means of an automatic testing system (6) comprising a processor capable of running a test sequence and a means for generating and measuring electric signals, said system being connected to the board (8) by means of an interfacing circuit (7) enabling application to the board of the stimuli issued by said generating means and measurement of the effects thereof by means of said measuring means,
characterised in that it uses a computer (1) connected to the testing system (6) and comprises the following phases:
- the introduction (10) into the computer (1) and formatting of the data describing the architecture of the electronic board (8) and serving for the automated manufacture of said board,
- the displaying (11), by the computer (1), of the electronic diagram of the board on a viewing screen (2), from said data,
- the dialogue (12,13,14) between the computer (1) and the operator by means of the diagram displayed on the screen (2) and a designating and control means (3,4), during which the operator defines a test sequence, this dialogue comprising the successive designation, by the operator, of equipotentials of the board to be tested, each of these designations causing the computer to display a generating and measuring means selection menu, the selection by the operator of one of these generating and measuring means causing the computer to display an image representing a control panel of the generating or measuring means selected, on which the operator can act in order to specify the required operating mode of the generating or measuring means selected,
- a first automatic running (16) of the test sequence on said testing system (6) or on a simulator, during which the electric signals measured by said measuring means are memorised, and
- a second automatic running of the test sequence on said testing system (6), during which the memorized signals are compared with the signals measured during said first run (16), the board (8) thus tested being declared to be in good working order if no differences have been detected during these comparisons.

2. Method as claimed in claim 1,
characterised in that, during the dialogue phase between the computer (1) and the operator, it comprises a stage involving modification and adaptation of the electronics diagram of the board displayed on the screen (2), as a function of the testing system (6) and of the type of test to be performed, by direct action on the part of the operator on the displayed diagram, via the designation and control means.

3. Method as claimed in claim 2,
characterised in that it comprises, subsequent to said first running (16), the formatting of the data used by the test sequence into a format compatible with the computer-assisted design tool.

4. Method as claimed in claim 1 or 2,
characterised in that said data serving for the automated manufacture of said board (8) are provided by a computer-assisted design tool.

5. Method as claimed in any one of the previous claims,
characterised in that it comprises the displaying (11), on the viewing screen (2), of the electronics diagram (30) and of the layout diagram (31) of the electronic components (34) and equipotentials of the board (8).

6. Method as claimed in any one of the previous claims,
characterised in that it comprises the successive designation, on said diagram displayed on the screen and by means of a designating means (4), of the equipotentials of the board to be tested and the allocation of the latter to test nails (Ci).

7. Method as claimed in any one of the previous claims,
characterised in that it comprises the successive designation (13), on said diagram displayed on the screen and by means of a designating means (4), of the equipotentials of the board and the selection of the type of signal, be it digital or analog, passing through the latter.

8. Method as claimed in claim 6,
characterised in that it comprises the automatic drawing up of the wiring plan of the interface (7) connecting the testing system and the board to be tested, subsequent to the selection of the type of signal passing through each equipotential.

9. Method as claimed any one of claims 5 to 7,
characterised in that the order in which the equipotentials are designated and in which said signals are defined determines the sequencing order of the test.

10. Method as claimed in any of the previous claims,
characterised in that it comprises the step-by-step running (15) of said test sequence, the displaying on the screen (2) and adjustment at each step by the operator of the parameters defining the shape of the signals to be applied (50) to and to be detected (51) at the different equipotentials (52,53) of the board (8).

11. Method as claimed in any one of the previous claims,
characterised in that all the data used for the test are stored and organised in the form of a database (5).

12. Method as claimed in any one of the previous claims,
characterised in that it comprises a mode for the interactive detection of failure, during which the points (33) indicated by the testing system (6), and on which the operator must place a sensor, are indicated on the layout diagram (31) of the components of the board (8) displayed on the viewing screen (2).

13. Method as claimed in any one of the previous claims,
characterised in that it comprises a mode for the interactive detection of failure, during which the equipotentials (29) indicated by the testing system (6), and on which the operator must place a sensor, are indicated on the electronics diagram (30) of the board (8) displayed on the viewing screen (2).

14. Device for implementing the method as claimed in any one of the previous claims,
characterised in that it comprises a central processing unit (1) connected to:
- a system (6) for the automatic testing of electronic boards, of the type comprising a processor capable of controlling a set of signal generating and measuring means, said system being connected to the electronic board (8) to be tested via an interface (7),
- at least one control device such as a keyboard (3) or a mouse (4),
- a viewing screen (2) on which is displayed the electronics diagram of the electronic board (8),
the central processing unit (1) enabling the operator to interactively connect, working from said diagram, said devices to the equipotentials of the electronic board, and to command them to apply stimuli thereto while viewing the effects thereof on the viewing screen (2).
